# EUROPEAN PATENT APPLICATION

(11) **EP 4 411 186 A1**
(43) Date of publication of application: **07.08.2024**
(21) Application number: 21960904.7
(22) Date of filing: 20.10.2021
(51) Int. Cl.: F16K 17/19

(54) **VALVE AND ELECTRONIC DEVICE**

(71) Applicant: Huawei Technologies Co., Ltd., Shenzhen, Guangdong 518129 (CN)
(72) Inventor: DU, Huan, Shenzhen, Guangdong 518129 (CN); XU, Ping, Shenzhen, Guangdong 518129 (CN); WU, Bin, Shenzhen, Guangdong 518129 (CN); YANG, Xiaojun, Shenzhen, Guangdong 518129 (CN)
(74) Representative: Gill Jennings & Every LLP
(86) International application number: PCT/CN2021/124969
(87) International publication number: WO 2023/065148

(57) **Abstract**

A valve and an electronic device are provided. The electronic device includes a housing. The housing is configured with an electronic component inside; and the valve is disposed on the housing. The valve includes: a valve body, where the valve body is provided with a channel, and the channel connects an inner side and an outer side of the housing on which the valve body is mounted; and a bolt body, where the bolt body is disposed on the valve body to close the channel, and when a pressure difference between the inner side and the outer side is greater than a threshold, the bolt body opens the channel. In this way, when the pressure difference between the inner side and the outer side is small, the bolt body may close the channel, so that water vapor on the outer side is prevented from entering the inner side. In addition, when the pressure difference between the inner side and the outer side is greater than the threshold, the bolt body may open the channel, so that the pressure difference between the inner side and the outer side can be balanced, and adverse impact caused by an excessively large pressure difference between the inner side and the outer side can be avoided; and when the pressure difference between the inner side and the outer side is reduced to a value less than the threshold, the bolt body may close the channel, so that water vapor on the outer side is prevented from entering the inner side. Therefore, a water vapor content on the inner side is reduced, a possibility of condensation is reduced, and impact of water vapor and condensation on the electronic component is reduced.

## Description

### TECHNICAL FIELD

This application relates to the field of electronic device technologies, and in particular, to a valve and an electronic device.

### BACKGROUND

As a means of transportation, a vehicle needs to be able to run normally in a plurality of complex environments. Because a large quantity of vehicle-mounted electronic components are disposed in the vehicle, to ensure normal driving of the vehicle, the vehicle-mounted electronic components are required to work normally in different environments. With continuous development of vehicle technologies, functions of the vehicle are increasingly rich and powerful, and a quantity of vehicle-mounted electronic components in the vehicle also increases accordingly. Therefore, a higher requirement is imposed on adaptability of the vehicle-mounted electronic components.

For example, in some rainy areas, because air humidity is high, when the vehicle is used in a season with a large diurnal temperature, like spring, autumn, or winter, or when the vehicle is used in a scenario with a short-time high temperature change, like a tunnel or a garage, absolute humidity (namely, quality of water vapor in humid air of each cubic meter) of air inside a module equipped with a vehicle-mounted electronic component exceeds a saturation point, the water vapor inside the module condenses to form water droplets, resulting in condensation. If the water droplets generated during condensation are attached to a position like a pin, a wiring solder joint, or a signal output solder joint of a chip or a component, the pin or the solder joint may be corroded. As a result, insulation and voltage resistance performance may be reduced. This finally damages the insulation performance, or even causes risks such as short circuit and board burning.

In addition, in a high humidity scenario, condensation directly causes corrosion or short circuit of the vehicle-mounted electronic component, and humidity also affects service life of the vehicle-mounted electronic component. Higher relative humidity of an environment in which the vehicle-mounted electronic component is located indicates shorter estimated life of the vehicle-mounted electronic component. Therefore, the relative humidity of the micro-environment in which the vehicle-mounted electronic component is located is maintained at a low level, so that the service life of the vehicle-mounted electronic component can be effectively prolonged.

### SUMMARY

This application provides a valve and an electronic device, to balance a pressure difference between an inner side and an outer side when the pressure difference between the inner side and the outer side is excessively large, reduce a possibility of condensation, and reduce impact of water vapor and condensation on an electronic component.

According to a first aspect of this application, a valve is provided. The valve includes: a valve body, where the valve body is provided with a channel, and the channel connects an inner side and an outer side of a housing on which the valve body is mounted; and a bolt body, where the bolt body is disposed on the valve body to close the channel, and when a pressure difference between the inner side and the outer side is greater than a threshold, the bolt body opens the channel.

In this way, in a normal case, to be specific, when the pressure difference between the inner side and the outer side is small, the bolt body may close the channel, so that water vapor on the outer side is prevented from entering the inner side. Increase of a water vapor content on the inner side is avoided, a possibility of condensation is reduced, and impact of water vapor and condensation on an electronic component is reduced. In addition, when the pressure difference between the inner side and the outer side is greater than the threshold, the bolt body may open the channel, so that the pressure difference between the inner side and the outer side can be balanced, and a risk of structural respiratory fatigue caused by an excessively large pressure difference between the inner side and the outer side can be avoided.

In a possible implementation of the first aspect, the bolt body includes: a first valve film, where when pressure on the inner side is greater than pressure on the outer side, and the pressure difference is greater than a first pressure difference threshold, the first valve film deforms to open the channel; and a second valve film, where when pressure on the outer side is greater than pressure on the inner side, and the pressure difference is greater than a second pressure difference threshold, the second valve film deforms to open the channel.

In this way, the first valve film may control the channel to be opened when the first pressure difference threshold is reached, to discharge air to the outer side and balance the pressure difference between the inner side and the outer side; and the second valve film may control the channel to be opened when the second pressure difference threshold is reached, to inhale air to the inner side and balance the pressure difference between the inner side and the outer side. In this way, air can be discharged and inhaled under different pressure difference thresholds according to requirements, so that the valve can be applied to more scenarios.

In a possible implementation of the first aspect, the first pressure difference threshold is greater than the second pressure difference threshold.

In this way, the valve can more easily discharge air on the inner side, so that a water vapor content on the inner side is reduced, and a possibility of condensation on the inner side is reduced.

In a possible implementation of the first aspect, the channel includes a first channel and a second channel. The bolt body includes: a first valve film, where the first valve film closes the first channel, and when pressure on the inner side is greater than pressure on the outer side, and the pressure difference is greater than a first pressure difference threshold, the first valve film deforms to open the first channel; and a second valve film, where the second valve film closes the second channel, and when pressure on the outer side is greater than pressure on the inner side, and the pressure difference is greater than a second pressure difference threshold, the second valve film deforms to open the second channel.

In this way, opening and closing of the first channel and the second channel may be separately controlled by the first valve film and the second valve film, to implement differentiated control on air inhale and air discharge, so that the valve can be applied to more scenarios. To be specific, when the pressure on the inner side is greater than the pressure on the outer side, and the pressure difference is greater than the first pressure difference threshold, the first valve film opens the first channel to discharge air to the outer side; and when the pressure on the outer side is greater than the pressure on the inner side, and the pressure difference is greater than the second pressure difference threshold, the second valve film opens the second channel to inhale air to the inner side.

In a possible implementation of the first aspect, the bolt body further includes: an isolation portion, where the isolation portion divides the channel into the first channel and the second channel.

In this way, the channel may be divided into the first channel and the second channel by using the isolation portion of the bolt body, so that a structure of the valve body is simplified, and production costs of the valve body are reduced.

In a possible implementation of the first aspect, the first valve film is provided with a first inclined portion, the first inclined portion presses against an inner surface of the channel, the first inclined portion is set to be in a shape where a shorter distance between the first inclined portion and a peripheral side of the first inclined portion indicates a shorter distance between the first inclined portion and the outer side, the second valve film is provided with a second inclined portion, the second inclined portion presses against the inner surface of the channel, and the second inclined portion is set to be in a shape where a shorter distance between the second inclined portion and a peripheral side of the second inclined portion indicates a shorter distance between the second inclined portion and the inner side.

In this way, when the pressure on the inner side is greater than the pressure on the outer side, a force generated when the pressure difference is exerted on the first valve film and the second valve film acts toward the outer side. Because a shorter distance between the first inclined portion and the peripheral side of the first inclined portion indicates a shorter distance between the first inclined portion and the outer side, when the force acting toward the outer side drives the first inclined portion to deform, the first inclined portion moves towards a direction away from the inner surface of the channel, so that the first channel is opened. Because a shorter distance between the second inclined portion and the peripheral side of the second inclined portion indicates a shorter distance between the second inclined portion and the inner side, when the force acting toward the outer side drives the second inclined portion to deform, the second inclined portion moves towards a direction close to the inner surface of the channel, so that the second channel remains closed. In contrast, when the pressure on the outer side is greater than the pressure on the inner side, a force generated when the pressure difference is exerted on the first valve film and the second valve film acts toward the inner side. In this way, the second inclined portion is driven to move towards a direction away from the inner surface of the channel, so that the second channel is opened; and the first inclined portion is driven to move towards a direction close to the inner surface of the channel, so that the first channel remains closed. Therefore, the first valve film is prevented from opening the first channel when the pressure on the outer side is greater than the pressure on the inner side, and the second valve film is prevented from opening the second channel when the pressure on the inner side is greater than the pressure on the outer side. The first valve film can control opening of the first channel only when the pressure on the inner side is greater than the pressure on the outer side, to discharge air and balance the pressure difference between the inner side and the outer side; and the second valve film can control opening of the second channel only when the pressure on the outer side is greater than the pressure on the inner side, to inhale air and balance the pressure difference between the inner side and the outer side.

In a possible implementation of the first aspect, the first inclined portion and the second inclined portion are in a straight line shape or an arc shape in an extension direction towards the peripheral side.

In a possible implementation of the first aspect, a distance between the first inclined portion and the outer side is less than a distance between the second inclined portion and the inner side when the first inclined portion and the second inclined portion extend to the peripheral sides by a same distance. In this way, when a force, exerted on the first valve film, towards the outer side is the same as a force, exerted on the second valve film, towards the inner side, according to the trigonometric function principle, a component force of the first inclined portion in a deformation direction is greater than a component force of the second inclined portion in a deformation direction. Therefore, the first pressure difference threshold is less than the second pressure difference threshold. It is easier for the valve to discharge air, so that a water vapor content on the inner side is reduced, and a possibility of condensation on the inner side is reduced. In addition, it is more difficult for the valve to inhale air, so that a possibility of water vapor on the outer side entering the inner side is reduced, and a possibility of condensation on the inner side is reduced.

In a possible implementation of the first aspect, the bolt body includes a main body, a first vent hole and a second vent hole are formed on the main body, the first valve film covers an outer side of the first vent hole, and the second valve film covers an inner side of the second vent hole. In this way, the first valve film may cover the outer side of the first vent hole, so that the first valve film opens the first vent hole when the pressure on the inner side is greater than the pressure on the outer side, and keeps the first vent hole closed when the pressure on the outer side is greater than the pressure on the inner side. The second valve film may cover the inner side of the second vent hole, so that the second valve film opens the second vent hole when the pressure on the outer side is greater than the pressure on the inner side, and keeps the second vent hole closed when the pressure on the inner side is greater than the pressure on the outer side. In this way, the first valve film may control the channel to discharge air; and the second valve film may control the channel to inhale air.

In a possible implementation of the first aspect, there are a plurality of first valve films and a plurality of second valve films, the plurality of first valve films are inclined to be in contact with and cover the first vent hole in a protrusion shape facing the outer side, and the plurality of second valve films are inclined to be in contact with and cover the second vent hole in a protrusion shape facing the inner side. In this way, the plurality of first valve films are in contact with each other to form the protrusion shape facing the outer side. When the pressure on the inner side is greater than the pressure on the outer side, the plurality of first valve films may be driven to deform towards separate directions, so that the first vent hole is opened. When the pressure on the outer side is greater than the pressure on the inner side, the plurality of first valve films may be driven to deform towards directions that are close to each other, so that the first vent hole remains closed. The plurality of second valve films are in contact with each other to form the protrusion shape facing the inner side. When the pressure on the outer side is greater than the pressure on the inner side, the plurality of second valve films may be driven to deform towards separate directions, so that the second vent hole is opened. When the pressure on the inner side is greater than the pressure on the outer side, the plurality of second valve films may be driven to deform towards directions that are close to each other, so that the second vent hole remains closed.

In a possible implementation of the first aspect, a thickness of the first valve film is less than a thickness of the second valve film. Therefore, a force required for driving deformation of the first valve film may be less than a force required for driving deformation of the second valve film. Therefore, the first pressure difference threshold is less than the second pressure difference threshold. It is easier for the valve to discharge air, so that a water vapor content on the inner side is reduced, and a possibility of condensation on the inner side is reduced. In addition, it is more difficult for the valve to inhale air, so that a possibility of water vapor on the outer side entering the inner side is reduced, and a possibility of condensation on the inner side is reduced.

In a possible implementation of the first aspect, when the first valve film and the second valve film close the channel, a first rebound force exerted on the first valve film is less than a second rebound force exerted on the second valve film. In this way, after a first deformation force and a second deformation force are generated due to deformation when the first valve film and the second valve film close the channel, the first rebound force and the second rebound force are correspondingly exerted on the first valve film and the second valve film. To drive the first valve film and the second valve film to continue to deform to open the channel, the first deformation force and the second deformation force need to be overcome. Therefore, when the first rebound force is less than the second rebound force, the first pressure difference threshold when the first valve film is opened may be less than the second pressure difference threshold when the second valve film is opened. It is easier for the valve to discharge air, so that a water vapor content on the inner side is reduced, and a possibility of condensation on the inner side is reduced. It is more difficult for the valve to inhale air, so that a possibility of water vapor on the outer side entering the inner side is reduced, and a possibility of condensation on the inner side is reduced.

In a possible implementation of the first aspect, the first valve film or the second valve film is made of silica gel, ethylene propylene diene monomer, plastic, or metal. In this way, a material suitable for manufacturing the first valve film and the second valve film is provided, so that the first valve film and the second valve film can deform when the pressure difference between the inner side and the outer side is within a corresponding threshold. Therefore, the channel can be opened, and atmospheric pressure on the inner side and the outer side can be balanced.

In a possible implementation of the first aspect, the first pressure difference threshold and the second pressure difference threshold are greater than 10 Pa. In this way, a range of the first pressure difference threshold and a range of the second pressure difference threshold are provided, so that it can be avoided that a requirement on the pressure difference between the inner side and the outer side and a water vapor content cannot be met due to an excessively small pressure difference between the inner side and the outer side.

In a possible implementation of the first aspect, the valve further includes: a sealing ring, where the sealing ring is sleeved outside the valve body; and a connecting portion, connecting the sealing ring and the bolt body, where a notch is disposed on a side wall of the channel for the connecting portion to pass through. In this way, a position at which an outer part of the valve body is connected to the housing may be sealed by using the sealing ring, so that sealing performance of the housing is improved, and intrusion of water vapor is avoided.

In a possible implementation of the first aspect, the valve further includes: a waterproofing gas-permeable membrane, where the waterproofing gas-permeable membrane is disposed onto the channel. The disposition of the waterproofing gas-permeable membrane can ensure ingress and egress of gas, and prevent liquid water on the outer side from entering the inner side through the channel to bring impact to the electronic component on the inner side. The disposition of the bolt body can enhance functionality of the waterproofing gas-permeable membrane, and reduce water vapor from gas that enters the inner side through the waterproofing gas-permeable membrane. This improves waterproof effect.

According to a second aspect of this application, an electronic device is provided. The electronic device includes: a housing, where the housing is configured with an electronic component inside; and a valve, where the valve is disposed on the housing, and the valve is any possible implementation form of the valve in the first aspect of this application. In this way, a bolt body may close a channel, so that water vapor on an outer side of the housing is prevented from entering an inner side of the housing. Therefore, a water vapor content on the inner side of the housing is reduced, a possibility of condensation is reduced, and impact of water vapor and condensation on the electronic component is reduced. In addition, when a pressure difference between the inner side and the outer side of the housing is greater than a threshold, the bolt body may open the channel, so that the pressure difference between the inner side and the outer side of the housing can be balanced, and adverse impact caused by an excessively large pressure difference between the inner side and the outer side can be avoided.

According to a third aspect of this application, a vehicle is provided. The vehicle includes the electronic device in the second aspect of this application.

These aspects and another aspect of this application will be clearer and easier to understand in descriptions of the following (a plurality of) embodiments.

### BRIEF DESCRIPTION OF DRAWINGS

The following further describes features of this application and a relationship between the features with reference to the accompanying drawings. The accompanying drawings are all examples, and some features are not shown in actual proportions. In addition, in some accompanying drawings, common features that are not mandatory for this application in the field of this application may be omitted. Alternatively, additional features that are not mandatory for this application are shown. A combination of the features shown in the accompanying drawings is not intended to limit this application. In addition, in this specification, content referred to by same reference numerals is also the same. The specific accompanying drawings are described as follows:
FIG. 1 is a schematic diagram of a usage scenario of a vent valve according to an embodiment of this application;
FIG. 2 is a schematic structural diagram of a vehicle-mounted controller according to an embodiment of this application;
FIG. 3 is a schematic structural diagram of a connection between a vent valve and a housing in FIG. 2;
FIG. 4 is a schematic structural diagram of the vent valve in FIG. 2;
FIG. 5 is a schematic exploded view of the vent valve in FIG. 2;
FIG. 6 is a schematic orthographic projection diagram of a bottom of the vent valve in FIG. 2;
FIG. 7 is a sectional view of the vent valve in FIG. 6 in an A-A direction;
FIG. 8 is a schematic structural diagram of a valve body in FIG. 4;
FIG. 9 is an orthographic projection view of a bottom of the valve body;
FIG. 10 is a schematic structural diagram of an axial direction of a bolt body and a sealing ring according to an embodiment of this application;
FIG. 11 is a schematic structural diagram of another axial direction of the bolt body and the sealing ring according to an embodiment of this application;
FIG. 12 is a sectional view of the bolt body and the valve body in FIG. 7 in a B-B direction;
FIG. 13 is a sectional view of the bolt body and the valve body in FIG. 7 in a C-C direction;
FIG. 14 is a partial enlarged view of a position of the bolt body in FIG. 7;
FIG. 15 is another schematic structural diagram of an axial direction of the bolt body and the sealing ring according to an embodiment of this application;
FIG. 16 is a top view of the bolt body and the sealing ring in FIG. 15;
FIG. 17 is a schematic sectional view of the bolt body and the sealing ring in FIG. 16 in a D-D direction;
FIG. 18 is another top view of the bolt body and the sealing ring according to an embodiment of this application;
FIG. 19 is a schematic sectional view of the bolt body and the sealing ring in FIG. 18 in an E-E direction;
FIG. 20 is another schematic structural diagram of a connection between the vent valve and the housing; and
FIG. 21 is a schematic structural diagram of the bolt body in FIG. 20.

### Descriptions of reference numerals:

1: vehicle; 10: battery pack; 20: motor; 30: headlights; 40: vehicle-mounted controller; 410: housing; 411: mounting hole; 50: vent valve; 510: valve body; 511: channel; 511a: first channel; 511b: second channel; 512: first mounting end; 513: second mounting end; 514: clamping connector; 515: notch; 516: connector; 517: mounting platform; 520: waterproofing gas-permeable membrane; 530: protective cover; 540: sealing ring; 550: bolt body; 551: first valve film; 551a: first inclined portion; 552: second valve film; 552a: second inclined portion; 553: isolation portion; 554: main body; 555: first vent hole; 556: second vent hole; 560: connecting portion; 570: fastener; 571: mounting portion.

### DESCRIPTION OF EMBODIMENTS

In this specification and claims, the terms "first, second, third, and the like" or similar terms such as a module A, a module B, and a module C are merely used to distinguish between similar objects, and do not represent a specific order of the objects. It may be understood that specific orders or sequences may be exchanged if permitted, so that embodiments of this application described herein can be implemented in an order other than an order illustrated or described herein.

The term "include" used in this specification and claims should not be construed as being limited to the content listed below, and does not exclude other elements or steps. Instead, the term "include" should be construed as specifying existence of a mentioned feature, whole, step, or part, but does not preclude existence or addition of one or more other features, wholes, steps, or parts and their groups. Therefore, the expression "a device including an apparatus A and an apparatus B" should not be limited to a device including only the components A and B.

"One embodiment" or "an embodiment" mentioned in this specification indicates that a particular feature, structure, or property that is described with reference to the embodiment is included in at least one embodiment of the present invention. Therefore, the terms "in one embodiment" or "in an embodiment" that appear in this specification do not necessarily indicate a same embodiment, but may indicate a same embodiment. Further, in one or more embodiments, the particular features, structures, or properties can be combined in any proper manner, as will be clear from this disclosure to a person of ordinary skill in the art.

To control humidity and avoid impact of condensation on an electronic component, one solution is to dispose the electronic component in a sealed housing, and improve air tightness of the electronic component, to avoid condensation. However, if the housing is completely sealed, when an atmospheric pressure difference occurs between an inner side and an outer side of the housing, the housing is exposed to a risk of structural respiratory (where structure expansion is caused when internal pressure is excessively high, or structure compression is caused when internal pressure is excessively low) fatigue. Therefore, a vent valve needs to be disposed on the housing to balance the atmospheric pressure difference between the inner side and the outer side of the housing. Because the vent valve cannot avoid intrusion of water vapor, condensation may still occur in the housing in a severe scenario.

Embodiments of this application provide a vent valve, to reduce water vapor entering a housing, thereby reducing a possibility of condensation in the housing.

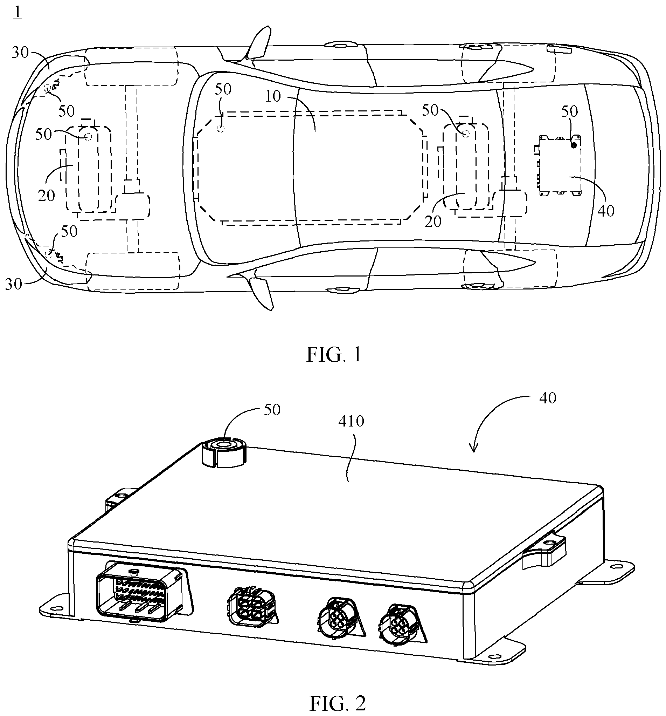

FIG. 1 is a schematic diagram of a usage scenario of a vent valve 50 according to an embodiment of this application. As shown in FIG. 1, electronic devices such as a battery pack 10, a motor 20, headlights 30, and a vehicle-mounted controller 40 are disposed in a vehicle 1. The vehicle-mounted controller 40 may be a mobile data center (Mobile Data Center, MDC), a vehicle control unit (Vehicle Control Unit, VCU), a cockpit domain controller (Cockpit Domain Controller, CDC), or the like. The MDC serves as an intelligent driving controller. To ensure that the vehicle 1 can run normally in a plurality of complex environments, these electronic devices are usually disposed in a sealed housing 410. The vent valve 50 is disposed on the housing 410. The vent valve 50 may be closed when a pressure difference between an inner side and an outer side of the housing 410 is within a predetermined value, or may be opened when a pressure difference between an inner side and an outer side of the housing 410 exceeds a predetermined value, so that the pressure difference between the inner side and the outer side is balanced. Therefore, intrusion of water vapor into the housing 410 is reduced, a water vapor content in the housing 410 is reduced, and a possibility of condensation in the housing 410 is reduced.

In this embodiment of this application, an example in which the vehicle 1 is a vehicle is used for description. This should not be considered as a limitation on embodiments of this application. The vehicle 1 may be a conventional fuel vehicle, or may be a new energy vehicle, for example, a pure electric vehicle or a hybrid vehicle. The vehicle 1 may be any one of different types of vehicles such as a car, a truck, a passenger bus, and a sport utility vehicle (sport utility vehicle, SUV). The vehicle 1 may alternatively be a means of transportation in another form, for example, a ship or an airplane. Alternatively, the vent valve 50 in embodiments of this application is not limited to being disposed on the vehicle 1, and may be further disposed in another device that needs to reduce a water vapor content and has an anti-condensation requirement.

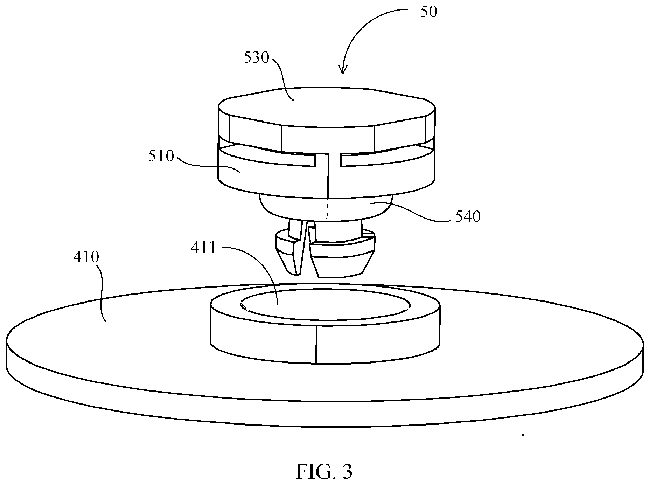

FIG. 2 is a schematic structural diagram of a vehicle-mounted controller 40 according to an embodiment of this application. FIG. 3 is a schematic structural diagram of a connection between the vent valve 50 and the housing 410 in FIG. 2. The vehicle-mounted controller 40 is used as an example to show a specific mounting manner of the vent valve 50 on the electronic device. As shown in FIG. 2 and FIG. 3, the vehicle-mounted controller 40 is provided with the sealed housing 410. The housing 410 may protect an electronic component on an inner side of the housing 410, so that the electronic component is isolated from air on an outer side of the housing 410. The "sealed" herein means that a part other than the vent valve 50 is sealed. A mounting hole 411 is disposed on the housing 410, and is configured to install the vent valve 50. A pressure difference between the inner side and the outer side of the housing 410 may be balanced by using the vent valve 50. A specific connection between the vent valve 50 and the mounting hole 411 may be a clamping connection shown in FIG. 3, or may be a thread connection, welding, interference matching, or the like. This is not limited herein.

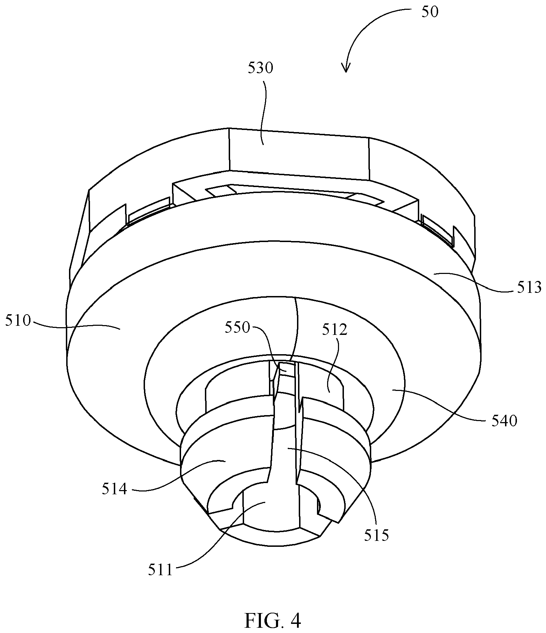

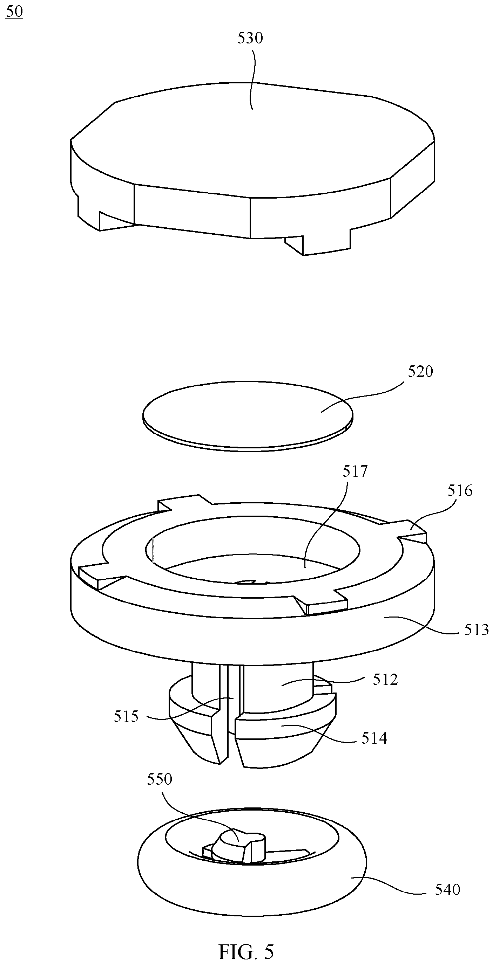

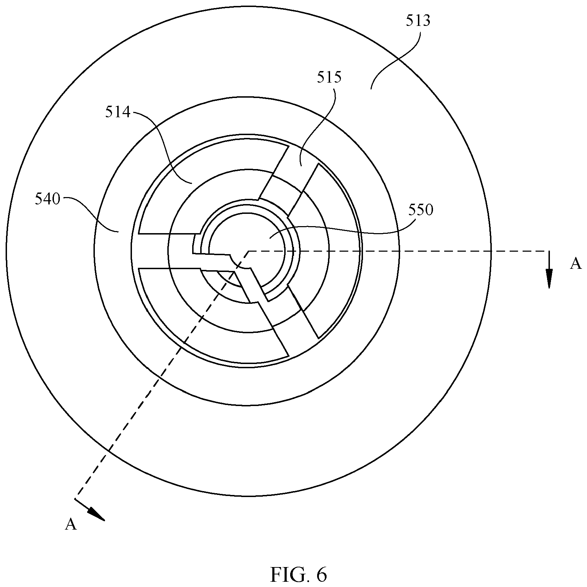

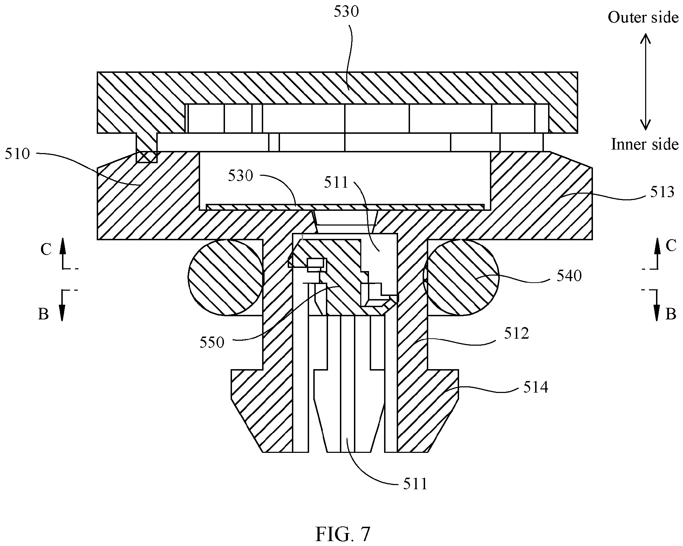

FIG. 4 is a schematic structural diagram of an axial side of the vent valve 50 in FIG. 2. FIG. 5 is a schematic exploded structural view of the vent valve 50 in FIG. 2. FIG. 6 is a schematic orthographic projection diagram of a bottom (a side entering the housing 410) of the vent valve 50 in FIG. 2. FIG. 7 is a sectional view of the vent valve 50 in FIG. 6 in an A-A direction. As shown in FIG. 4, FIG. 5, FIG. 6, and FIG. 7, the vent valve 50 includes a valve body 510, a waterproofing gas-permeable membrane 520, a protective cover 530, a sealing ring 540, and a bolt body 550. The valve body 510 is provided with a channel 511 connecting the inner side and the outer side of the housing 410. The bolt body 550 is disposed on the valve body 510 to close the channel 511, and when the pressure difference between the inner side and the outer side is greater than a predetermined threshold, the bolt body 550 opens the channel 511. In this way, when the pressure difference between the inner side and the outer side is small, the bolt body 550 may close the channel 511, so that air and water vapor on the outer side are prevented from entering the inner side. When the pressure difference between the inner side and the outer side is large, the bolt body 550 may open the channel 511, so that the pressure difference between the inner side and the outer side is balanced. In addition, after the pressure difference between the inner side and the outer side is reduced, the channel 511 is closed again, so that water vapor entering the inner side is reduced. Therefore, a water vapor content in the housing 410 can be reduced, so that a possibility of condensation in the housing 410 is reduced.

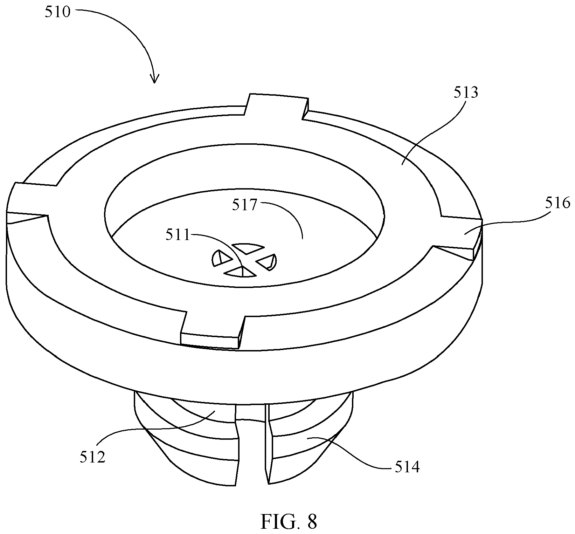

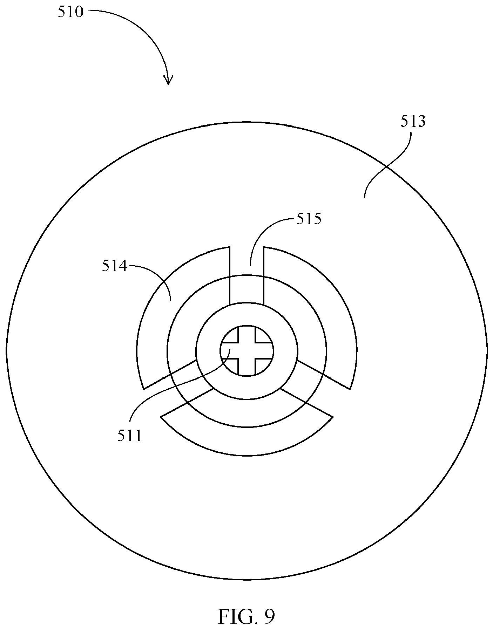

FIG. 8 is a schematic structural diagram of the valve body 510 in FIG. 4. FIG. 9 is an orthographic projection view of a bottom of the valve body 510. As shown in FIG. 4, FIG. 5, FIG. 8, and FIG. 9, the valve body 510 includes a first mounting end 512 and a second mounting end 513 that are coaxially arranged in a cylindrical shape. The channel 511 is disposed at an axis position of the valve body 510, passes through the valve body 510, and has openings on both the inner side and the outer side. A protrusion-shaped clamping connector 514 is disposed at an end of the first mounting end 512 in a circumferential direction. A notch 515 is disposed at the first mounting end 512 in an axial direction. There may be a plurality of notches 515, and the notches 515 pass through a side wall of the channel 511 in a radial direction. For example, as shown in FIG. 9, there may be four notches 515, and the first mounting end 512 is divided into four separate parts.

When the first mounting end 512 is inserted into the mounting hole 411 of the housing 410, the clamping connector 514 may deform towards an axis after pressing against the mounting hole 411, so that the first mounting end 512 can enter the mounting hole 411. When the clamping connector 514 passes through the mounting hole 411, the clamping connector 514 restores to the original shape after ending pressing against the housing 410, so that the valve body 510 can be clamped and fixed to the housing 410.

A connector 516 is disposed on an end surface of the second mounting end 513, and is configured to implement a fixed connection to a protective cover 530, so that the valve body 510 can be protected by using the protective cover 530. In addition, a gap is formed between the protective cover 530 and the end face of the second mounting end 513, so that the channel 511 in the second mounting end 513 is connected to the outside. The fixed connection between the connector 516 and the protective cover 530 may be clamping, sticking, fixing, or the like. This is not limited herein.

Two parts with different diameters are disposed in the channel 511 along an axial direction, and a part with a larger diameter in the channel 511 is located at a corresponding position at the second mounting end 513, so that the channel 511 forms a mounting platform 517 at the second mounting end 513. The mounting platform 517 is configured to mount a waterproofing gas-permeable membrane 520, where the waterproofing gas-permeable membrane 520 has a feature of preventing liquid from passing through and ensuring passage of gas. The disposition of the waterproofing gas-permeable membrane 520 onto the mounting platform 517 can prevent liquid water formed by condensation or other reasons from the outside from entering the housing 410 through the channel 511, and can ensure that air passes through the channel 511, so that the pressure difference between the inner side and the outer side of the housing 410 is balanced.

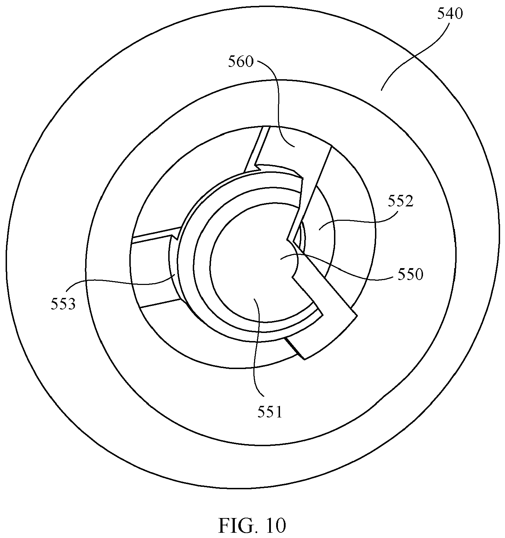

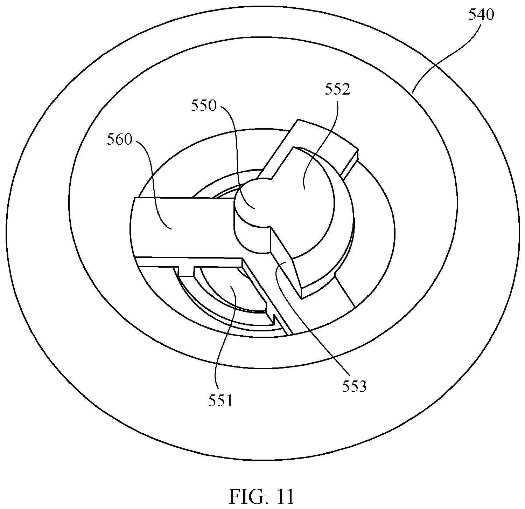

FIG. 10 is a schematic structural diagram of an axial direction of the bolt body 550 and the sealing ring 540 according to an embodiment of this application. FIG. 11 is a schematic structural diagram of another axial direction of the bolt body 550 and the sealing ring 540 according to an embodiment of this application. As shown in FIG. 5, FIG. 7, FIG. 10, and FIG. 11, the bolt body 550 and the sealing ring 540 may be integrally formed, and are connected to each other by using a connecting portion 560. After the bolt body 550 and the sealing ring 540 are mounted on the valve body 510, the bolt body 550 is located inside the channel 511, to close the channel 511. The sealing ring 540 is located outside the first mounting end 512. After the clamping connector 514 enters the mounting hole 411 of the housing 410 to implement clamping connection, the sealing ring 540 may be located in space between the first mounting end 512 and the mounting hole 411, to seal a connection position between the valve body 510 and the housing 410. The connecting portion 560 is disposed in correspondence with the notch 515 on the first mounting end 512. In this way, the connecting portion 560 can pass through the notch 515, so that the bolt body 550 and the sealing ring 540 that are integrally formed can be successfully mounted on the valve body 510.

As shown in FIG. 10 and FIG. 11, the connecting portion 560 may be in a Y-shaped shape, that is, have three branches. The three branches are disposed at an angle of 120° in a radial direction, and are connected at a central position of the sealing ring 540. The bolt body 550 includes a first valve film 551 and a second valve film 552. The first valve film 551 and the second valve film 552 each may be made of silica gel, ethylene propylene diene monomer, plastic, or metal. The first valve film 551 and the second valve film 552 may be sector-shaped components shown in FIG. 10 and FIG. 11, or may be elastic components in other shapes or forms. The first valve film 551 is considered as a sector at an angle of 120° in an axial direction, and is disposed on a surface that is of the connecting portion 560 and that faces the inner side. The second valve film 552 is a sector at an angle of 240°, and is disposed on a surface that is of the connecting portion 560 and that faces the outer side. The first valve film 551 and the second valve film 552 complement each other to form an entire 360° circle in the axial direction of the bolt body 550.

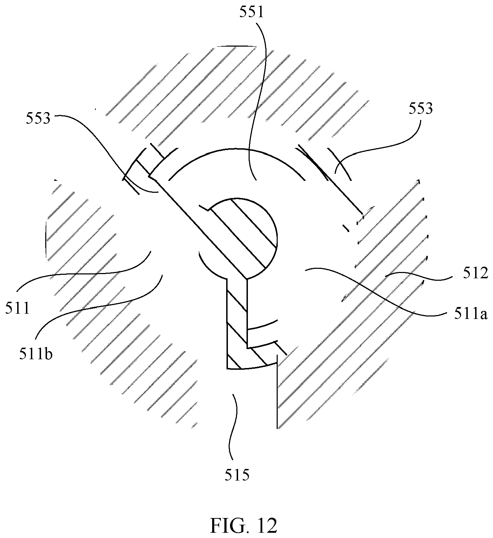

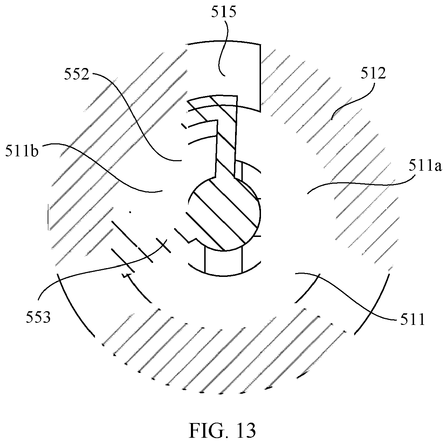

FIG. 12 is a sectional view of the bolt body 550 and the valve body 510 in FIG. 7 in a B-B direction. FIG. 13 is a sectional view of the bolt body 550 and the valve body 510 in FIG. 7 in a C-C direction. As shown in FIG. 10, FIG. 11, FIG. 12, and FIG. 13, an isolation portion 553 is disposed between an edge of the first valve film 551 and an edge of the second valve film 552 and the connecting portion 560, and the first valve film 551 and the second valve film 552 are connected to the connecting portion 560 by using the isolation portion 553. Peripheral sides (sides that are away from an axis of the channel 511 and that face an inner surface of the channel 511) of the first valve film 551 and the second valve film 552 press against the inner surface of the channel 511. The isolation portion 553 divides the channel 511 into a first channel 511a and a second channel 511b. The first valve film 551 closes the first channel 51 1a, and the second valve film 552 closes the second channel 51 1b. In this way, the bolt body 550 can close the channel 511.

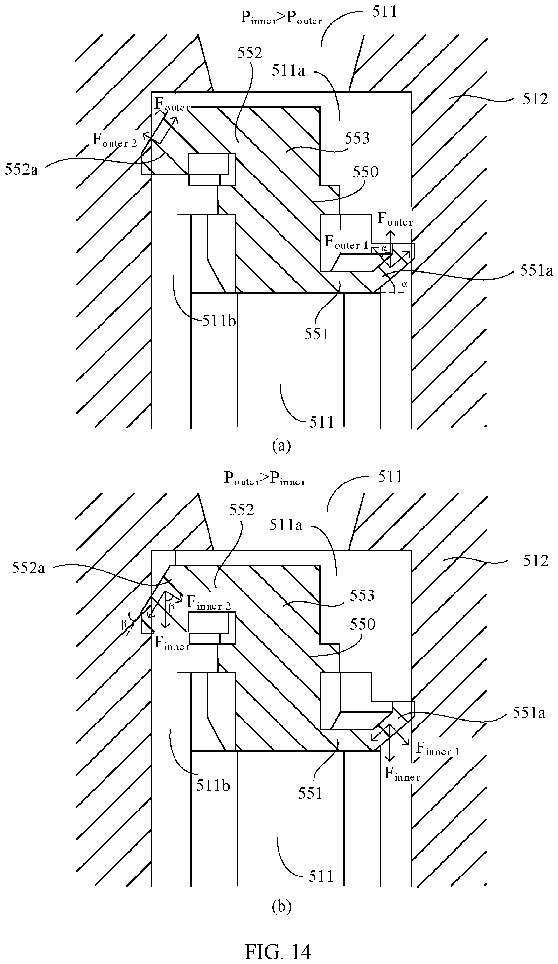

FIG. 14 is a partial enlarged view of a position of the bolt body 550 in FIG. 7. As shown in FIG. 10, FIG. 11, and FIG. 14, the peripheral side of the first valve film 551 is provided with a first inclined portion 551a, the first inclined portion 551a presses against the inner surface of the channel 511, and the first inclined portion 551a is set to be in a shape of inclining towards the outer side, that is, a shorter distance between the first inclined portion 551a and a peripheral side of the first inclined portion 551a indicates a shorter distance between the first inclined portion 551a and the outer side. The peripheral side of the second valve film 552 is provided with a second inclined portion 552a, the second inclined portion 552a presses against the inner surface of the channel 511, and the second inclined portion 552a is set to be in a shape of inclining towards the inner side, that is, a shorter distance between the second inclined portion 552a and a peripheral side of the second inclined portion 552a indicates a shorter distance between the second inclined portion 552a and the inner side. From the perspective of an axial section of the first inclined portion 551a and the second inclined portion 552a, directions in which the first inclined portion 551a and the second inclined portion 552a extend towards the peripheral sides each may be disposed in a straight line shape shown in FIG. 14, or may be disposed in an arc shape. This is not limited thereto. In this way, the first valve film 551 and the second valve film 552 are connected to the isolation portion 553, to form a bowl-shaped structure with an opening facing the outer side and a bowl-shaped structure with an opening facing the inner side.

Therefore, as shown in (a) in FIG. 14, when pressure Pᵢₙₙₑᵣ on the inner side of the housing 410 is greater than pressure Pₒᵤₜₑᵣ on the outer side of the housing 410, a force Fₒᵤₜₑᵣ towards the outer side is generated when the pressure difference ΔP between the inner side and the outer side is exerted on the first valve film 551 and the second valve film 552. Because the first inclined portion 551a inclines towards the outer side, when the pressure difference ΔP between the inner side and the outer side is large enough, that is, when the force Fₒᵤₜₑᵣ is large enough, a component force F_{outer 1} that is perpendicular to the first inclined portion 551a and that is obtained by exerting the force Fₒᵤₜₑᵣ on the first inclined portion 551a drives the first inclined portion 551a to deform towards a direction close to the axis, so that there may be a gap between the first inclined portion 551a and the inner surface of the channel 511, the first channel 511a is opened, and air is discharged from the inner side of the housing 410 to the outer side. Because the second inclined portion 552a inclines towards the inner side, a component force F_{outer 2} that is perpendicular to the second inclined portion 552a and that is obtained by exerting the force Fₒᵤₜₑᵣ on the second inclined portion 552a drives the second inclined portion 552a to deform towards a direction away from the axis, so that the second inclined portion 552a presses against the inner surface of the channel 511 more closely, and the second channel 511b remains closed.

Similarly, as shown in (b) in FIG. 14, when pressure Pₒᵤₜₑᵣ on the outer side of the housing 410 is greater than pressure Pᵢₙₙₑᵣ on the inner side of the housing 410, a force Fᵢₙₙₑᵣ towards the inner side is generated when the pressure difference ΔP between the outer side and the inner side is exerted on the first valve film 551 and the second valve film 552. Because the second inclined portion 552a inclines towards the inner side, when the pressure difference ΔP between the outer side and the inner side is large enough, that is, when the force Fᵢₙₙₑᵣ is large enough, a component force F_{inner 2} that is perpendicular to the second inclined portion 552a and that is obtained by exerting the force Fᵢₙₙₑᵣ on the second inclined portion 552a drives the second inclined portion 552a to deform towards a direction close to the axis, so that there may be a gap between the second inclined portion 552a and the inner surface of the channel 511, the second channel 511b is opened, and air is inhaled from the outer side of the housing 410 to the inner side of the housing 410. Because the first inclined portion 551a inclines towards the inner side, a component force F_{inner 1} that is perpendicular to the first inclined portion 551a and that is obtained by exerting the force Fᵢₙₙₑᵣ on the first inclined portion 551a drives the first inclined portion 551a to deform towards a direction away from the axis, so that the first inclined portion 551a presses against the inner surface of the channel 511 more closely, and the first channel 511a remains closed.

It is set that when a value that is obtained by subtracting the pressure Pₒᵤₜₑᵣ on the outer side of the housing 410 from the pressure Pᵢₙₙₑᵣ on the inner side of the housing 410 is greater than a first pressure difference threshold ΔP_{discharge}, air is discharged from the inner side of the housing 410 to the outer side of the housing 410. It is set that when a value that is obtained by subtracting the pressure Pᵢₙₙₑᵣ on the inner side of the housing 410 from the pressure Pₒᵤₜₑᵣ on the outer side of the housing 410 is greater than a second pressure difference threshold ΔPᵢₙₕₐₗₑ, air is inhaled from the outer side of the housing 410 to the inner side of the housing 410. As shown in FIG. 14, a thickness of the first valve film 551 is less than a thickness of the second valve film 552. Therefore, under a same condition, the force Fₒᵤₜₑᵣ required for driving the first valve film 551 to deform to open the first channel 511a is less than the force Fᵢₙₙₑᵣ required for driving the second valve film 552 to deform to open the second channel 511b. In this way, the first pressure difference threshold ΔP_{discharge} that needs to be exceeded during air discharge is less than the second pressure difference threshold ΔPᵢₙₕₐₗₑ that needs to be exceeded during air inhale, so that air is easy to be discharged and difficult to be inhaled, and a possibility that water vapor enters the inner side through the channel 511 is reduced.

Similarly, as shown in FIG. 14, the first valve film 551 and the second valve film 552 are mounted in the channel 511 in a deformed state. To be specific, because the first valve film 551 and the second valve film 552 are large in size, the first inclined portion 551a and the second inclined portion 552a press against the inner surface of the channel 511, and deformation occurs when the first channel 511a and the second channel 511b are closed. In this way, the first inclined portion 551a and the second inclined portion 552a generate deformation forces, and the deformation forces are exerted on the inner surface of the channel 511, so that the first inclined portion 551a and the second inclined portion 552a are subject to same rebound forces in opposite directions. The deformation force interacts with the rebound force, so that the first inclined portion 551a and the second inclined portion 552a are closely connected to the inner surface of the channel 511, to ensure sealing performance. A first deformation variable of deformation occurred when the first valve film 551 closes the first channel 511a is less than a second deformation variable of deformation occurred when the second valve film 552 closes the second channel 511b. A larger deformation variable indicates a larger deformation force that is correspondingly generated. Therefore, a first deformation force generated due to deformation of the first valve film 551 is less than a second deformation force generated due to deformation of the second valve film 552. Therefore, a first rebound force exerted on the first valve film 551 is less than a second rebound force exerted on the second valve film 552.

As shown in FIG. 14, the first deformation force and the second deformation force drive the first inclined portion 551a and the second inclined portion 552a to move in directions away from the axis. To be specific, a direction of the first deformation force is opposite to a direction of the component force F_{outer 1} that drives opening of the first channel 511a, and a direction of the second deformation force is opposite to a direction of the component force F_{inner 2} that drives opening of the second channel 511b. Therefore, the deformation forces increase a force F_{discharge} required for driving deformation of the first valve film 551 and a force Fᵢₙₕₐₗₑ required for driving deformation of the second valve film 552. Because the first deformation variable is less than the second deformation variable, under a same condition, the force F_{discharge} required for driving deformation of the first valve film 551 is less than the force Fiₙₕₐₗₑ required for driving deformation of the second valve film 552. In this way, the first pressure difference threshold ΔP_{discharge} that needs to be exceeded during air discharge is less than the second pressure difference threshold ΔPᵢₙₕₐₗₑ that needs to be exceeded during air inhale, so that air is easy to be discharged and difficult to be inhaled, and a possibility that water vapor enters the inner side through the channel 511 is reduced.

Similarly, as shown in FIG. 14, a distance between the first inclined portion 551a and the outer side is less than a distance between the second inclined portion 552a and the inner side when the first inclined portion 551a and the second inclined portion 552a extend to the peripheral sides by a same distance. To be specific, an angle α at which the first inclined portion 551a inclines towards the outer side is less than an angle β at which the second inclined portion 552a inclines towards the inner side. Therefore, it can be learned according to the trigonometric function principle that cosα>cosβ. Because F_{outer 1}=Fₒᵤₜₑᵣcosα, and F_{inner 2}=Fᵢₙₙₑᵣcosβ, under a same pressure difference, that is, when the force Fₒᵤₜₑᵣ exerted on the first valve film 551 is the same as the force Fᵢₙₙₑᵣ exerted on the second valve film 552, the component force F_{outer 1} in a deformation direction of the first inclined portion 551a is greater than the component force F_{inner 2} in a deformation direction of the second inclined portion 552a. Therefore, under a same condition, the force F_{discharge} required for driving deformation of the first valve film 551 is less than the force Fᵢₙₕₐₗₑ required for driving deformation of the second valve film 552. In this way, the first pressure difference threshold ΔP_{discharge} that needs to be exceeded during air discharge is less than the second pressure difference threshold ΔPᵢₙₕₐₗₑ that needs to be exceeded during air inhale, so that air is easy to be discharged and difficult to be inhaled, and a possibility that water vapor enters the inner side through the channel 511 is reduced.

In conclusion, the first valve film 551 may be used to control the first pressure difference threshold ΔP_{discharge} that needs to be exceeded when the vent valve 50 discharges air, and the second valve film 552 may be used to control the second pressure difference threshold ΔPᵢₙₕₐₗₑ that needs to be exceeded when the vent valve 50 inhales air. Therefore, a working principle of the vent valve 50 in this embodiment of this application is as follows:

When Pᵢₙₙₑᵣ>Pₒᵤₜₑᵣ, and Pᵢₙₙₑᵣ-Pₒᵤₜₑᵣ>ΔP_{discharge}, the first inclined portion 551a deforms, the first channel 511a is opened, and air on the inner side of the vent valve 50 is discharged to the outer side of the vent valve 50 through the first channel 511a. In this way, the pressure difference between the inner side and the outer side of the vent valve 50 can be balanced, and a part of water vapor on the inner side can be discharged, so that the water vapor on the outer side is prevented from entering the inner side of the vent valve 50, a concentration of the water vapor on the inner side is reduced, and a possibility of condensation on the inner side is reduced.

When Pₒᵤₜₑᵣ>Pᵢₙₙₑᵣ, and Pₒᵤₜₑᵣ-Pᵢₙₙₑᵣ>ΔPᵢₙₕₐₗₑ, the second inclined portion 552a deforms, the second channel 511b is opened, and air on the outer side of the vent valve 50 is inhaled to the inner side of the vent valve 50 through the second channel 51 1b. In this way, the pressure difference between the inner side and the outer side of the vent valve 50 can be balanced, to avoid damage to the housing 410 due to an excessively large pressure difference. In addition, after the pressure difference between the inner side and the outer side is less than or equal to the second pressure difference threshold ΔPᵢₙₕₐₗₑ, the second inclined portion 552a can be restored to the original shape of the second inclined portion 552a under exertion of the deformation force, so that the second channel 511b is closed again. In this way, more water vapor is prevented from entering the inner side of the vent valve 50, and increase of a concentration of water vapor on the inner side of the vent valve 50 is avoided.

When Pᵢₙₙₑᵣ=Pₒᵤₜₑᵣ; when Pᵢₙₙₑᵣ>Pₒᵤₜₑᵣ, and Pᵢₙₙₑᵣ-Pₒᵤₜₑᵣ<ΔP_{discharge}; or when Pₒᵤₜₑᵣ>Pᵢₙₙₑᵣ, and Pₒᵤₜₑᵣ-Pᵢₙₙₑᵣ<ΔPᵢₙₕₐₗₑ, the first inclined portion 551a and the second inclined portion 552a remain stationary, and the first channel 511a and the second channel 511b remain in a closed state. In this way, water vapor can be prevented from entering the inner side of the vent valve 50, and increase of a concentration of water vapor on the inner side of the vent valve 50 can be avoided.

Further, based on a requirement of the vehicle-mounted controller 40, when the vehicle-mounted controller 40 is, for example, an MDC, the first pressure difference threshold ΔP_{discharge} and the second pressure difference threshold ΔPᵢₙₕₐₗₑ each may be set to be greater than 10 Pa. In this way, it can be avoided that a requirement of the MDC on the pressure difference between the inner side and the outer side and a water vapor content cannot be met due to an excessively small pressure difference between the inner side and the outer side.

Further, the vent valve in this embodiment of this application may be disposed on the electronic devices such as the battery pack 10, the motor 20, the headlights 30, and the vehicle-mounted controller 40, and is configured to enable air to be easily discharged and difficultly inhaled when the atmospheric pressure difference between the inner side and the outer side is balanced, so that the water vapor content is reduced. The vent valve may be further disposed on another device, and is configured to balance a pressure difference that is generated between the inner side and the outer side and that is of hydraulic pressure, for example, water or oil. In addition, when the pressure difference that is between the inner side and the outer side and that is of the hydraulic pressure is balanced, the liquid can be easily discharged and difficultly inhaled, so that harmful substances entering the inner side are reduced, and a harmful substance content on the inner side is reduced.

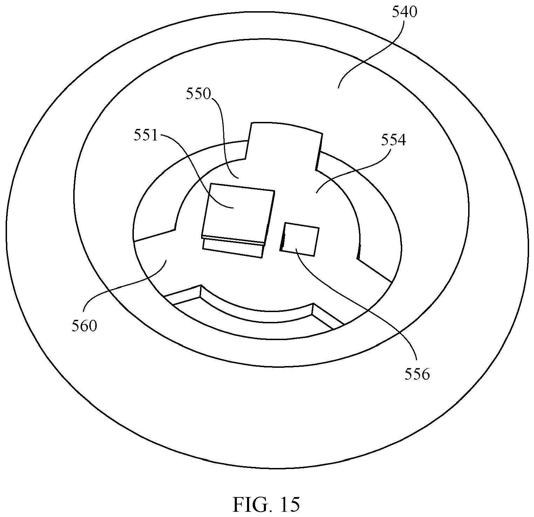

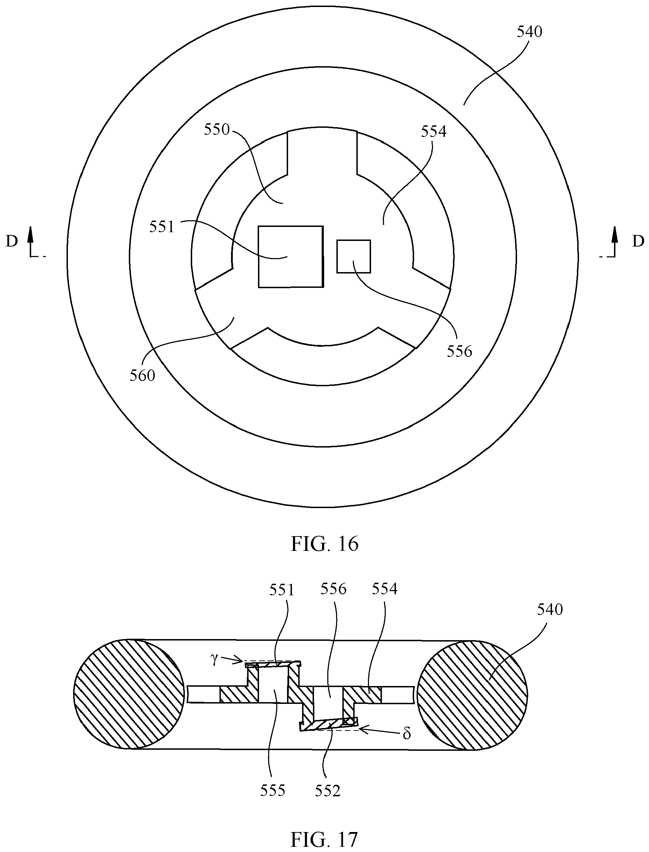

FIG. 15 is another schematic structural diagram of an axial direction of the bolt body 550 and the sealing ring 540 according to an embodiment of this application. FIG. 16 is a top view of the bolt body 550 and the sealing ring 540 in FIG. 15. FIG. 17 is a schematic sectional view of the bolt body 550 and the sealing ring 540 in FIG. 16 in a D-D direction. As shown in FIG. 15, FIG. 16, and FIG. 17, an embodiment of this application further provides another possible structural form of the bolt body 550 and the sealing ring 540. A difference between the bolt body 550 in FIG. 15, FIG. 16, and FIG. 17 and the bolt body 550 in FIG. 10 and FIG. 11 is that the bolt body 550 includes a main body 554. The main body 554 is located at a central position of the sealing ring 540, and is fixedly connected to the sealing ring 540 by using a connecting portion 560. After the bolt body 550 and the valve body 510 are mounted, the main body 554 is located in the channel 511, and the channel 511 is divided into two parts: an outer side and an inner side that are separated along an axial direction. A first vent hole 555 and a second vent hole 556 are disposed on the main body 554, and shapes of cross sections of the first vent hole 555 and the second vent hole 556 each may be a square shown in FIG. 15, FIG. 16, and FIG. 17, or may be a circle or another shape. A first valve film 551 covers and is disposed at a position of an opening part of an outer side of the first vent hole 555. A part of the first valve film 551 is fixedly connected to a part of an edge of the opening part of the outer side of the first vent hole 555, and the other parts press against each other. A second valve film 552 covers and is disposed at a position of an opening part of an inner side of the second vent hole 556. A part of the second valve film 552 is fixedly connected to a part of an edge of the opening part of the inner side of the second vent hole 556, and the other parts press against each other.

In this way, when pressure Pᵢₙₙₑᵣ on the inner side of the housing 410 is greater than pressure Pₒᵤₜₑᵣ on the outer side of the housing 410, and the pressure difference is greater than a first pressure difference threshold ΔP_{discharge}, the first valve film 551 and the second valve film 552 deform towards the outer side under the pressure, so that a gap is generated at a position at which the first valve film 551 presses against the first vent hole 555. In this way, the first channel 511a is opened, so that air on the inner side is discharged to the outer side through the first channel 511a. In addition, the second valve film 552 presses against the second vent hole 556 more closely. In this way, the second channel 511b remains in a closed state. When pressure Pₒᵤₜₑᵣ on the inner side of the housing 410 is greater than pressure Pᵢₙₙₑᵣ on the outer side of the housing 410, and the pressure difference is greater than a second pressure difference threshold ΔPᵢₙₕₐₗₑ, the first valve film 551 and the second valve film 552 deform towards the inner side under the pressure, so that the first valve film 551 presses against the first vent hole 555 more closely. In this way, the first channel 511a remains in a closed state. In addition, a gap is generated at a position at which the second valve film 552 presses against the second vent hole 556. In this way, the second channel 511b is opened, so that air on the outer side is inhaled into the inner side through the second channel 511b.

As shown in FIG. 15, FIG. 16, and FIG. 17, the opening part of the outer side of the first vent hole 555 and the opening part of the inner side of the second vent hole 556 are in a protrusion shape, so that a contact area between the first valve film 551 and the first vent hole 555 and a contact area between the second valve film 552 and the second vent hole 556 are reduced. In this way, pressure generated when the first valve film 551 presses against the second valve film 552 and pressure generated when the first vent hole 555 presses against the second vent hole 556 can be increased, and sealing performance can be improved when the first channel 511a and the second channel 511b are closed.

As shown in FIG. 17, a thickness of the first valve film 551 is less than a thickness of the second valve film 552. In this way, the first pressure difference threshold ΔP_{discharge} that needs to be exceeded by the pressure difference during air discharge is less than the second pressure difference threshold ΔPᵢₙₕₐₗₑ that needs to be exceeded by the pressure difference during air inhale, so that air is easy to be discharged and difficult to be inhaled, and a possibility that water vapor enters the inner side through the channel 511 is reduced.

As shown in FIG. 17, protrusions of the opening part of the outer side of the first vent hole 555 and the opening part of the inner side of the second vent hole 556 are disposed horizontally in the radial direction of the channel 511, and the first valve film 551 and the second valve film 552 are mounted on the first vent hole 555 and the second vent hole 556 in a deformation manner. The first valve film 551 is fixedly connected to the first vent hole 555 at an angle γ. In this way, the first valve film 551 undergoes first deformation and presses against the edge of the opening part of the outer side of the first vent hole 555, and a first deformation force generated by the first deformation drives the first valve film 551 to move towards the first vent hole 555, so that a first rebound force is generated. The first deformation force interacts with the first rebound force, so that the first valve film 551 seals the first vent hole 555. The second valve film 552 is fixedly connected to the second vent hole 556 at an angle δ. In this way, the second valve film 552 undergoes second deformation and presses against the edge of the opening part of the inner side of the second vent hole 556, and a second deformation force generated by the second deformation drives the second valve film 552 to move towards the second vent hole 556, so that a second rebound force is generated. The second deformation force interacts with the second rebound force, so that the second valve film 552 seals the second vent hole 556.

As shown in FIG. 17, γ<δ. Therefore, a first deformation variable is less than a second deformation variable. In other words, the first deformation force and the first rebound force are less than the second deformation force and the second rebound force. In this way, the first pressure difference threshold ΔP_{discharge} that needs to be exceeded during air discharge is less than the second pressure difference threshold ΔPᵢₙₕₐₗₑ that needs to be exceeded during air inhale, so that air is easy to be discharged and difficult to be inhaled, and a possibility that water vapor enters the inner side through the channel 511 is reduced.

Further, a radial cross-sectional area of the first vent hole 555 may be set to be greater than that of the second vent hole 556, and correspondingly, an area of the first valve film 551 is set to be greater than that of the second valve film 552, so that a part where the first valve film 551 presses against the first vent hole 555 is greater than a part where the second valve film 552 presses against the second vent hole 556. Therefore, a force for driving the first valve film 551 to deform to open the first channel 511a is less than a force for driving the second valve film 552 to deform to open the second channel 511b. In this way, the first pressure difference threshold ΔP_{discharge} that needs to be exceeded during air discharge is less than the second pressure difference threshold ΔPᵢₙₕₐₗₑ that needs to be exceeded during air inhale, so that air is easy to be discharged and difficult to be inhaled, and a possibility that water vapor enters the inner side through the channel 511 is reduced.

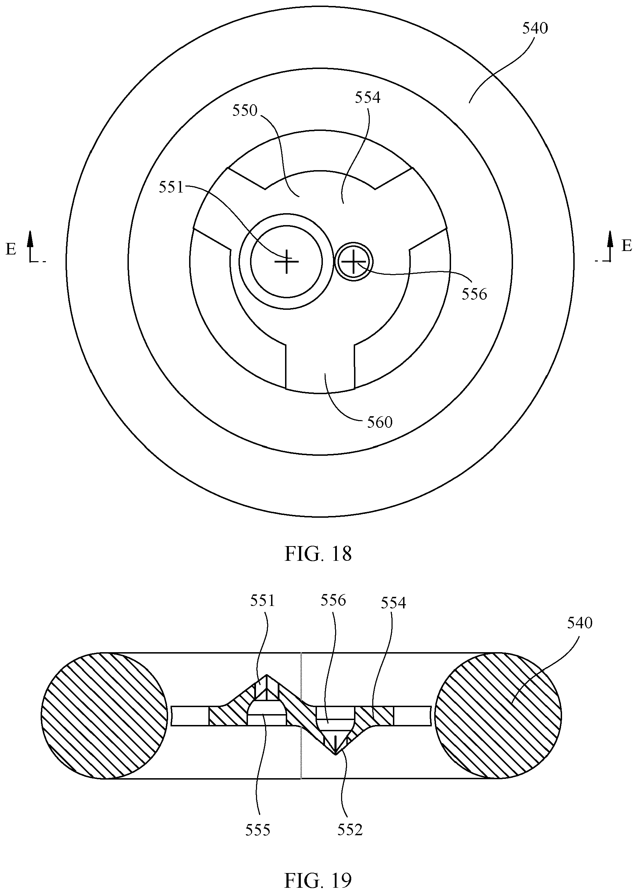

FIG. 18 is another top view of the bolt body 550 and the sealing ring 540 according to an embodiment of this application. FIG. 19 is a schematic sectional view of the bolt body 550 and the sealing ring 540 in FIG. 18 in an E-E direction. As shown in FIG. 18 and FIG. 19, an embodiment of this application further provides another possible structural form of the bolt body 550 and the sealing ring 540. A difference between the bolt body 550 in FIG. 18 and FIG. 19 and the bolt body 550 in FIG. 15, FIG. 16, and FIG. 17 is that a first vent hole 555 and a second vent hole 556 are circular through holes. Four first valve films 551 are disposed on an outer side of the first vent hole 555 around an opening part of the first vent hole 555. The four first valve films 551 are disposed in an inclined manner towards the outer side, and each first valve film 551 is in contact with an adjacent first valve film 551, to form a conical protrusion-shaped structure. Four second valve films 552 are disposed on an inner side of the second vent hole 556 around an opening part of the second vent hole 556. The four second valve films 552 are disposed in an inclined manner towards the inner side, and each second valve film 552 is in contact with an adjacent second valve film 552, to form a conical protrusion-shaped structure.

In this way, when pressure Pᵢₙₙₑᵣ on the inner side of the housing 410 is greater than pressure Pₒᵤₜₑᵣ on the outer side of the housing 410, and the pressure difference is greater than a first pressure difference threshold ΔP_{discharge}, a force formed when the pressure difference is exerted on the first valve films 551 drives the first valve films 551 to deform towards separate directions, so that a gap is generated between the first valve films 551. In this way, the first channel 511a is opened, so that air on the inner side is discharged to the outer side through the first channel 511a. In addition, a force formed when the pressure difference is exerted on the second valve films 552 drives the second valve films 552 to deform towards directions that are close to each other, so that the second valve films 552 are in contact with each other more closely. In this way, the second channel 511b remains closed. When pressure Pₒᵤₜₑᵣ on the inner side of the housing 410 is greater than pressure Pᵢₙₙₑᵣ on the outer side of the housing 410, and the pressure difference is greater than a second pressure difference threshold ΔPᵢₙₕₐₗₑ, a force formed when the pressure difference is exerted on the second valve films 552 drives the second valve films 552 to deform towards separate directions, so that a gap is generated between the second valve films 552. In this way, the second channel 511b is opened, so that air on the outer side is inhaled into the inner side through the second channel 511b. In addition, a force formed when the pressure difference is exerted on the first valve films 551 drives the first valve films 551 to deform towards directions that are close to each other, so that the first valve films 551 are in contact with each other more closely. In this way, the first channel 511a remains closed.

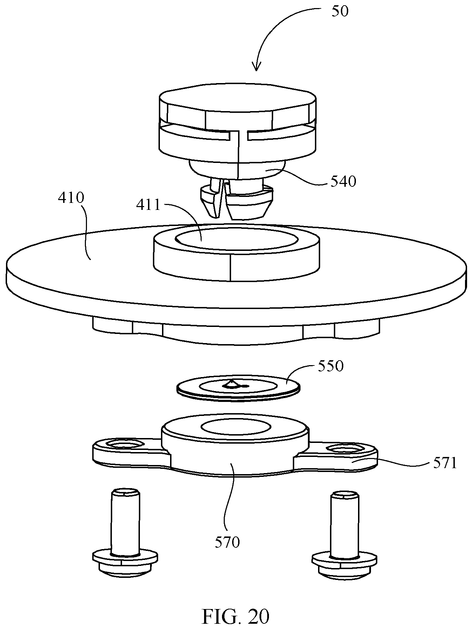

FIG. 20 is another schematic structural diagram of a connection between the vent valve 50 and the housing 410. As shown in FIG. 20, an embodiment of this application further provides another mounting form of the bolt body 550. Compared with those in FIG. 3, the bolt body 550 and the sealing ring 540 may alternatively be two separate components. After clamping connection is performed on the valve body 510 and the mounting hole 411 on the housing 410, the valve body 510 is tightly fixed to an inner side of the mounting hole 411 by using a fastener 570.

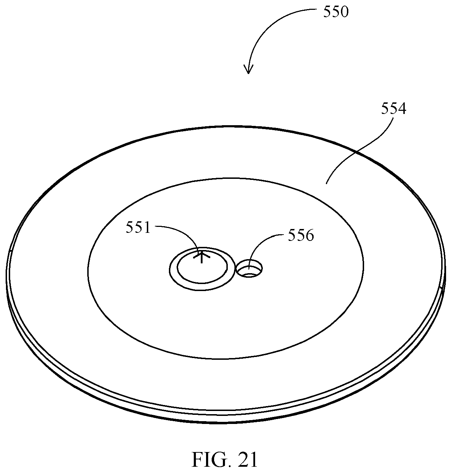

FIG. 21 is a schematic structural diagram of the bolt body 550 in FIG. 20. As shown in FIG. 21, the valve body 510 includes a main body 554 that is integrally in a disk shape. A first vent hole 555, a second vent hole 556, a first valve film 551, and a second valve film 552 that are the same as those in FIG. 18 and FIG. 19 are disposed in the middle of the valve body 510. Therefore, a specific manner in which the valve body 510 performs opening and closing is not described in detail herein. As shown in FIG. 20, the fastener 570 is integrally in a ring shape. A mounting portion 571 is disposed at two ends of the fastener 570, and may be fixed to an inner side of the mounting hole 411 by using bolts. After the mounting, the valve body 510 is located between the fastener 570 and the mounting hole 411, and an edge part of the main body 554 is pressed by using the fastener 570, to implement press-fitting and fixing of the valve body 510. The valve body 510 may control opening and closing of the channel 511.

It should be noted that the foregoing are merely preferred embodiments of this application and used technical principles. A person skilled in the art may understand that this application is not limited to specific embodiments described herein, and a person skilled in the art may make various obvious changes, readjustments, and replacements without departing from the protection scope of this application. Therefore, although this application is described in detail with reference to the foregoing embodiments, this application is not limited to the foregoing embodiments. More other equivalent embodiments may be included without departing from the concept of this application, and all fall within the protection scope of this application.

## Claims

1. A valve, comprising:
a valve body (510), wherein the valve body (510) is provided with a channel (511), and the channel (511) connects an inner side and an outer side of a housing (410) on which the valve body (510) is mounted; and
a bolt body (550), wherein the bolt body (550) is disposed on the valve body (510) to close the channel (511), and when a pressure difference between the inner side and the outer side is greater than a threshold, the bolt body (550) opens the channel (511).

2. The valve according to claim 1, wherein
the channel (511) comprises a first channel (511a) and a second channel (511b); and
the bolt body (550) comprises:
a first valve film (551), wherein the first valve film (551) closes the first channel (511a), and when pressure on the inner side is greater than pressure on the outer side, and the pressure difference is greater than a first pressure difference threshold, the first valve film (551) deforms to open the first channel (511a); and
a second valve film (552), wherein the second valve film (552) closes the second channel (511b), and when pressure on the outer side is greater than pressure on the inner side, and the pressure difference is greater than a second pressure difference threshold, the second valve film (552) deforms to open the second channel (511b).

3. The valve according to claim 2, wherein the bolt body (550) further comprises:
an isolation portion (553), wherein the isolation portion (553) divides the channel (511) into the first channel (511a) and the second channel (511b).

4. The valve according to claim 2 or 3, wherein
the first valve film (551) is provided with a first inclined portion (551a), the first inclined portion (551a) presses against an inner surface of the channel (511), the first inclined portion (551a) is set to be in a shape that a shorter distance between the first inclined portion (551a) and a peripheral side of the first inclined portion (551a) indicates a shorter distance between the first inclined portion (551a) and the outer side, the second valve film (552) is provided with a second inclined portion (552a), the second inclined portion (552a) presses against the inner surface of the channel (511), and the second inclined portion (552a) is set to be in a shape that a shorter distance between the second inclined portion (552a) and a peripheral side of the second inclined portion (552a) indicates a shorter distance between the second inclined portion (552a) and the inner side.

5. The valve according to claim 4, wherein a distance between the first inclined portion (551a) and the outer side is less than a distance between the second inclined portion (552a) and the inner side when the first inclined portion (551a) and the second inclined portion (552a) extend to the peripheral sides by a same distance.

6. The valve according to any one of claims 1 to 5, wherein
the bolt body (550) comprises a main body (554), a first vent hole (555) and a second vent hole (556) are formed on the main body (554), the first valve film (551) covers an outer side of the first vent hole (555), and the second valve film (552) covers an inner side of the second vent hole (556).

7. The valve according to claim 6, wherein
there are a plurality of first valve films (551) and a plurality of second valve films (552), the plurality of first valve films (551) are inclined to each other to be in contact with and cover the first vent hole (555) and are shaped like protrusions towards the outer side, and the plurality of second valve films (552) are inclined to each other to be in contact with and cover the second vent hole (556) and are shaped like protrusions towards the inner side.

8. The valve according to any one of claims 2 to 7, wherein
a thickness of the first valve film (551) is less than a thickness of the second valve film (552).

9. The valve according to any one of claims 2 to 8, wherein
when the first valve film (551) and the second valve film (552) close the channel, a first rebound force exerted on the first valve film (551) is less than a second rebound force exerted on the second valve film (552).

10. The valve according to any one of claims 2 to 9, wherein
the first valve film (551) or the second valve film (552) is made of silica gel, ethylene propylene diene monomer, plastic, or metal.

11. The valve according to any one of claims 1 to 10, wherein
the first pressure difference threshold and the second pressure difference threshold are greater than 10 Pa.

12. The valve according to any one of claims 1 to 11, further comprising:
a sealing ring (540), wherein the sealing ring is sleeved outside the valve body (510); and
a connecting portion (560), connecting the sealing ring (540) and the bolt body (550), wherein
a notch (515) is disposed on a side wall of the channel (511) for the connecting portion (560) to pass through.

13. The valve according to any one of claims 1 to 12, further comprising:
a waterproofing gas-permeable membrane (520), wherein the waterproofing gas-permeable membrane (520) is disposed onto the channel (511).

14. An electronic device, comprising:
a housing (410), wherein the housing (410) is configured with an electronic component inside; and
a valve, wherein the valve is disposed on the housing (410), and the valve is the valve according to any one of claims 1 to 13.
